Europäisches Patentamt

European Patent Office

Office européen des brevets

(19)

(11) EP 1 146 142 A2

(12) **EUROPEAN PATENT APPLICATION**

(43) Date of publication:
17.10.2001 Bulletin 2001/42

(51) Int Cl.⁷: **C23C 16/40**, C23C 16/505,
H01L 21/316, H01J 37/32

(21) Application number: 01303474.9

(22) Date of filing: 12.04.2001

| | |
|---|---|
| (84) Designated Contracting States:<br>**AT BE CH CY DE DK ES FI FR GB GR IE IT LI LU<br>MC NL PT SE TR**<br>Designated Extension States:<br>**AL LT LV MK RO SI** | (72) Inventors:<br>• **Ma, Wen**<br>  **Milpitas, California 95035 (US)**<br>• **M'Saad, Hichem**<br>  **Santa Clara, CA 95051 (US)** |
| (30) Priority: **14.04.2000 US 549817** | (74) Representative: **Allard, Susan Joyce et al**<br>**BOULT WADE TENNANT,**<br>**Verulam Gardens**<br>**70 Gray's Inn Road**<br>**London WC1X 8BT (GB)** |
| (71) Applicant: **Applied Materials, Inc.**<br>**Santa Clara, California 95054 (US)** | |

(54) **Process for forming fluorosilicate glass layers using high density plasma, for copper damascene integrated circuits**

(57)    A method of depositing a thin film on a substrate in a process chamber. In the method a high-density plasma, generated from a gaseous mixture of silicon containing, oxygen containing and fluorine containing gases deposits a layer of fluorinated silicate glass(FSG) onto the substrate. The substrate is biased at a bias power density of 1.3 Watts per square centimeter or less during deposition of the FSG layer. In a specific embodiment, the substrate is biased at a power level of 0.0 W/cm$^2$ (and thus is not biased at all) and in some embodiments the plasma generating system applies a total source power to the plasma of about 20.7 Watts per square centimeter or greater. In a preferred embodiment, the gases flow to the chamber such that a ratio of a flow rate of the fluorine containing gas to a combined flow rate of the silicon containing and fluorine containing gases is less than about 0.55. Furthermore, in the preferred embodiment, a flow rate of the oxygen containing gas to the combined flow rates of the silicon containing and fluorine containing gases is greater than about 1.5.

FIG. 4

**EP 1 146 142 A2**

## Description

The present invention relates to the manufacture of integrated circuits, and more specifically, to a method of formation of a barrier layer for dual damascene processes. FSG films deposited according to the present invention may be used in a variety of applications and are particularly useful in the formation of intermetal dielectric layers for copper damascene applications.

In conventional integrated circuit fabrication, circuit elements are formed by etching a pattern of gaps in a layer of metal such as aluminum. The gaps are then filled with a dielectric such as silicon dioxide. Copper, which has lower resistance compared to conventional aluminum alloys, is poised to take over as the main on-chip conductor for all types of integrated circuits. Unfortunately it is difficult to etch copper and therefore, damascene processes have developed for fabrication of copper-based integrated circuits. In damascene processes, dielectric layers are deposited as an integrated stack. The integrated stack is then etched to form gaps that are subsequently filled with copper. The dielectric layers that separate layers of copper in a damascene structure are often referred to as intermetal dielectric (IMD) layers. IMD layers typically include a barrier layer to prevent diffusion of copper into adjacent dielectric layers. Some integrated stacks used in damascene processes also utilize a layer known as an etch stop or hardmask to provide for selective etching of the film. Silicon nitride ($Si_xN_y$) is commonly used as a barrier layer or etch stop in damascene applications, for example when forming vias between layers containing metal lines.

Modern integrated circuits often utilize dielectrics having a dielectric constant lower than that of conventional silicon oxides to the speed of operation of integrated circuit elements by reducing RC time delays. Fluorine-doped silicon oxide, also known as fluorosilicate glass (FSG) is one attractive solution to replace conventional silicon dioxide as intermetal dielectrics for damascene structures. Among other deposition techniques, FSG films for damascene applications can be deposited in conventional high-density plasma chemical vapor deposition (HDP-CVD) systems which have been widely used to deposit undoped silicate glass (USG) and FSG dielectrics in gap-fill applications with aluminum interconnects. Gap-fill applications generally process the wafer in a plasma while applying a bias to the wafer. The bias accelerates ions from the plasma to the wafer. The ions bombard the wafer and sputter away material that might prematurely close the gap while material from the plasma simultaneously deposits to fill the gap. The FSG gap-fill process is a good process scheme in terms of reliability, stability and throughput. The electrical performance of integrated circuits can be significantly improved due to the lower dielectric constant of FSG. For example, HDP-FSG films deposited in gap-fill applications typically have a fluorine concentration of about 5.5-7.0 atomic percent (at. %) and a dielectric constant k between 3.5 and 3.7 compared to a k of 4.1 to 4.3 for conventional undoped silicon oxides. The lower dielectric constant reduces the capacitance between metal lines in the same layer and reduces cross talk across layers.

While HDP-FSG films have been used successfully in gap-fill applications, problems have been reported when the films are used for damascene applications. Specifically, damascene applications sometimes include a silicon nitride ($Si_xN_y$) layer deposited between dielectric layers as a barrier layer or etch stop, for example when forming vias between layers containing metal lines. Even with low at. % fluorine, e.g., between 2-3 at. %, adhesion problems between the silicon nitride and an underlying or overlying layer of blanket deposited HDP-FSG have been reported. Specifically, fluorine from the FSG layer tends to outgas during subsequent processing forming "bubbles" at the interface of the overlying $Si_xN_y$. The formation of such bubbles may lead to delamination of the silicon nitride layer.

Therefore, techniques for depositing FSG films having improved adhesion to overlying or underlying layers of silicon nitride are desirable.

The present invention provides such an improved HDP-FSG deposition technique. Embodiments of the invention solve the problems and disadvantages associated with prior art deposition techniques by applying little or no bias to the substrate during deposition of the HDP-FSG layer. The inventors have found that the films deposited according to embodiments of the present invention have improved adherence to overlying and underlying silicon nitride layers as compared to prior art films. Embodiments of the method of the present invention are particularly applicable to damascene processes in which a silicon nitride layer is deposited over an FSG layer and/or damascene processes in which an FSG layer is deposited over a silicon nitride layer.

In one embodiment of the method of the present invention a gas delivery system provides a gaseous mixture of silicon containing, oxygen containing and fluorine containing gases to the chamber. A plasma generating system generates a high-density plasma (a plasma having an ion density of $1 \times 10^{11}$ ions/cm$^3$ or greater) from the gaseous mixture. The plasma generating system applies a bias to the substrate at a bias power density of about 1.3 Watts per square centimeter or less to heat the substrate while depositing a dielectric layer onto the substrate with the plasma. In a specific embodiment of the method, the plasma generating system applies a total source power to the plasma of about 20.7 Watts per square centimeter or greater.

In one particular, preferred embodiment no bias power (0 Watts/cm$^3$) is applied to the substrate during deposition of the FSG layer. In some embodiments gases are flowed into the chamber such that a ratio of a flow rate of the fluorine containing gas to a combined flow rate of the silicon containing and fluorine containing gases is less than or equal to 0.55. Also, in some preferred embodiments, a ratio of the flow rate of the oxygen containing gas to the combined flow rates of the silicon containing and fluorine containing gases is greater than or equal to 1.5.

The method of the present invention may be embodied in a computer readable storage medium having a computer-readable program embodied therein for directing operation of a substrate processing system. Such a system may include a process chamber; a plasma generation system; a substrate holder; a gas delivery system, and a system controller. The computer-readable program includes instructions for operating the substrate processing system to form a thin film on a substrate disposed in the processing chamber in accordance with embodiments of the above method.

These and other embodiments of the present invention, as well as its advantages and features are described in more detail in conjunction with the text below and attached figures, provided by way of example.

Fig. 1A is a simplified diagram of one embodiment of a high density chemical vapor deposition system according to the present invention;

Fig. 1B is a simplified vertical cross section of a gas ring that may be used in conjunction with the exemplary CVD processing chamber of Fig. 1A;

Fig. 1C is a simplified horizontal cross section of a gas ring that may be used in conjunction with the exemplary CVD processing chamber of Fig. 1A;

Fig. 1D is a simplified diagram of a monitor and light pen that may be used in conjunction with the exemplary CVD processing chamber of Fig. 1A;

Fig. 1E is a flow chart of an exemplary process control computer program product used to control the exemplary CVD processing chamber of Fig. 1A;

Fig. 2 is a simplified cross-sectional view of a semiconductor device manufactured according to the method of the present invention;

Fig. 3 is a cross-sectional view of a dielectric thin film deposited according to an embodiment of the method of the present invention;

Fig. 4 is a flow diagram of one embodiment of the method of the present invention used in a copper damascene process;

Figs. 5(a)-5(h) depict a cross-section of a partially formed integrated circuit undergoing an integrated dual-damascene process according to an embodiment of the present invention;

Fig. 6 depicts a graph of % fluorine versus dielectric constant for FSG films deposited in accordance with embodiments of the method of the present invention;

Fig. 7 is a graph comparing RF bias power employed during deposition of HDP-FSG layers with a percentage of surface bubbling created during a subsequent heat treatment cycle;

Fig. 8 depicts a graph of % fluorine versus the ratio of $SiF_4/SiH_4$ for FSG films deposited in accordance with embodiments of the method of the present invention;

Fig. 9 depicts a graph of % fluorine versus $O_2/(SiH_4 +SiF_4)$ ratio for FSG films deposited in accordance with embodiments of the method of the present invention;

Fig. 10 depicts a graph of refractive index versus $O_2/(SiH_4 +SiF_4)$ ratio for FSG films deposited in accordance with embodiments of the method of the present invention;

Fig. 11 depicts a graph of FSG deposition rate versus $O_2/(SiH_4 +SiF_4)$ ratio for FSG films deposited in accordance with embodiments of the method of the present invention;

Fig. 12 depicts a graph of $SiF_2$ ratio versus $SiF_4/(SiF_4 + SiH_4)$ ratio for FSG films deposited in accordance with embodiments of the method of the present invention;

Fig. 13 depicts a graph of deposition rate as a function of total source RF power for HDP-FSG deposition according an embodiment of the present invention; and

Fig. 14 depicts a graph of % F as a function of total source RF power for HDP-FSG deposition according an embodiment of the present invention.

I. Introduction

Embodiments of the method of the present invention optimize the source power, bias power and gas flow rates during deposition of fluorinated silicate glass (FSG). The resulting FSG layer exhibits excellent adhesion to an overlying or underlying barrier layer such as silicon nitride ($Si_xN_y$). Embodiments of the present method also optimize the deposition rate and reduce non-uniformity of thickness and fluorine concentration across the wafer for blanket deposition of FSG by HDP-CVD. Embodiments of the method can be used in IMD applications.

II. Exemplary Substrate Processing System

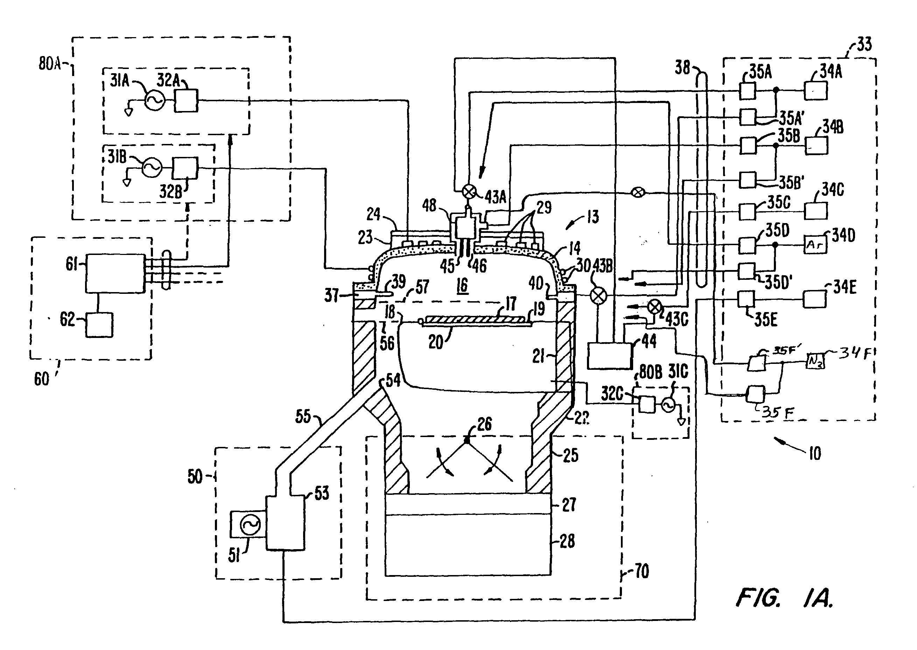

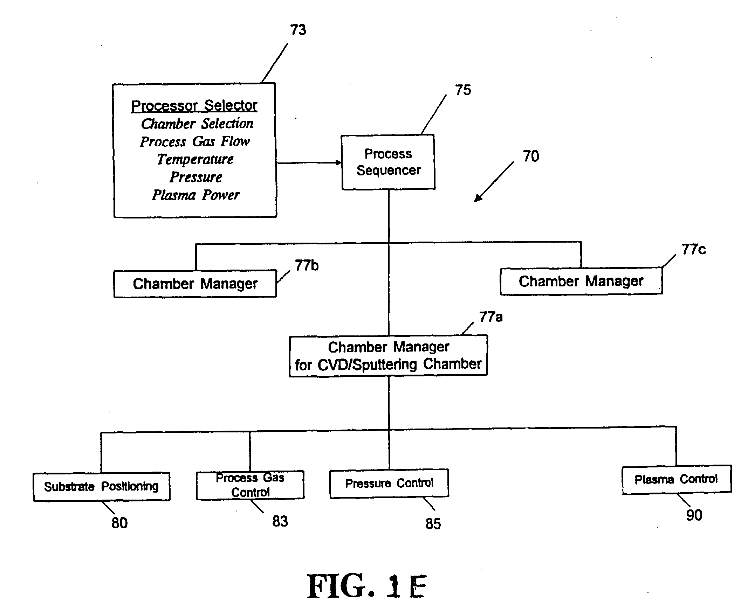

Fig. 1A illustrates one embodiment of a high density plasma chemical vapor deposition (HDP-CVD) system 10 in which a dielectric layer according to the present invention can be deposited. System 10 includes a chamber 13, a vacuum system 70, a source plasma system 80A, a bias plasma system 80B, a gas delivery system 33, and a remote plasma cleaning system 50.

The upper portion of chamber 13 includes a dome 14, which is made of a ceramic dielectric material, such as aluminum oxide or aluminum nitride. Dome 14 defines an upper boundary of a plasma processing region 16. Plasma processing region 16 is bounded on the bottom by the upper surface of a substrate 17 and a substrate support member 18.

A heater plate 23 and a cold plate 24 surmount, and are thermally coupled to, dome 14. Heater plate 23 and cold plate 24 allow control of the dome temperature to within about $\pm$ 10°C over a range of about 100°C to 200°C. This allows optimizing the dome temperature for the various processes. For example, it may be desirable to maintain the dome at a higher temperature for cleaning or etching processes than for deposition processes. Accurate control of the dome temperature also reduces the flake or particle counts in the chamber and improves adhesion between the deposited layer and the substrate.

The lower portion of chamber 13 includes a body member 22, which joins the chamber to the vacuum system. A base portion 21 of substrate support member 18 is mounted on, and forms a continuous inner surface with, body member 22. Substrates are transferred into and out of chamber 13 by a robot blade (not shown) through an insertion/removal opening (not shown) in the side of chamber 13. Lift pins (not shown) are raised and then lowered under the control of a motor (also not shown) to move the substrate from the robot blade at an upper loading position 57 to a lower processing position 56 in which the substrate is placed on a substrate receiving portion 19 of substrate support member 18. Substrate receiving portion 19 includes an electrostatic chuck 20 that secures the substrate to substrate support member 18 during substrate processing. In a preferred embodiment, substrate support member 18 is made from an aluminum oxide or aluminum ceramic material.

Vacuum system 70 includes throttle body 25, which houses twin-blade throttle valve 26 and is attached to gate valve 27 and turbo-molecular pump 28. It should be noted that throttle body 25 offers minimum obstruction to gas flow, and allows symmetric pumping, as described in co-pending, co-assigned U.S. Patent Application No. 08/574,839, filed December 12, 1995, and which is incorporated herein by reference. Gate valve 27 can isolate pump 28 from throttle body 25, and can also control chamber pressure by restricting the exhaust flow capacity when throttle valve 26 is fully open. In one embodiment the arrangement of the throttle valve, gate valve, and turbo-molecular pump allow accurate and stable control of chamber pressures from between about 1 millitorr to about 2 Torr and provide a pumping capacity of 22 liters/min.

The source plasma system 80A includes a top coil 29 and side coil 30, mounted on dome 14. A symmetrical ground shield (not shown) reduces electrical coupling between the coils. Top coil 29 is powered by top source RF (SRF) generator 31A, whereas side coil 30 is powered by side SRF generator 31B, allowing independent power levels and frequencies of operation for each coil. This dual coil system allows control of the radial ion density in chamber 13, thereby improving plasma uniformity. Side coil 30 and top coil 29 are typically inductively driven, which does not require a complimentary electrode. In a specific embodiment, the top source RF generator 31A provides up to 2,500 watts of RF power at nominally 2 MHz and the side source RF generator 31B provides up to 5,000 watts of RF power at between 1.8 and 2.2 MHz nominally 2 MHz. The operating frequencies of the top and side RF generators may be offset from the nominal operating frequency (e. g. to 1.7-1.9 MHz and 1.9-2.1 MHz, respectively) to improve plasma-generation efficiency.

A bias plasma system 80B includes a bias RF (BRF) generator 31C and a bias matching network 32C. The bias plasma system 80B capacitively couples substrate portion 17 to body member 22 which act as complimentary electrodes. The bias plasma system 80B serves to enhance the transport of plasma species (e. g., ions) created by the source plasma system 80A to the surface of the substrate. BRF generator 31C provides RF power at a frequency ranging from about 1-100. In a specific embodiment, BRF generator 31C provides up to 5,000 watts of RF power at 13.56 MHz.

RF generators 31A and 31B include digitally controlled synthesizers and operate over a frequency range between about 1.8 to about 2.2 MHz. Each generator includes an RF control circuit (not shown) that measures reflected power from the chamber and coil back to the generator and adjusts the frequency of operation to obtain the lowest reflected power, as is understood to a person of ordinary skill in the art. RF generators are typically designed to operate into a load with a characteristic impedance of 50 ohms. RF power may be reflected from loads that have a different characteristic impedance than the generator. This can reduce power transferred to the load. Additionally, power reflected from the load back to the generator may overload and damage the generator. Because the impedance of a plasma may range from less than 5 ohms to over 900 ohms, depending on the plasma ion density, among other factors, and because reflected power may be a function of frequency, adjusting the generator frequency according to the reflected power increases the power transferred from the RF generator to the plasma and protects the generator. Another way to reduce reflected power and improve efficiency is with a matching network.

Matching networks 32A and 32B match the output impedance of generators 31A and 31B with their respective coils 29 and 30. The RF control circuit may tune both matching networks by changing the value of capacitors within the matching networks to match the generator to the load as the load changes. The RF control circuit may tune a matching network when the power reflected from the load back to the generator exceeds a certain limit. One way to provide a constant match, and effectively disable the RF control circuit from tuning the matching network, is to set the reflected power limit above any expected value of reflected power. This may help stabilize a plasma under some conditions by holding the matching network constant at its most recent condition.

Other measures may also help stabilize a plasma. For example, the RF control circuit can be used to determine the power delivered to the load (plasma) and may increase or decrease the generator output power to keep the delivered power substantially constant during deposition of a layer.

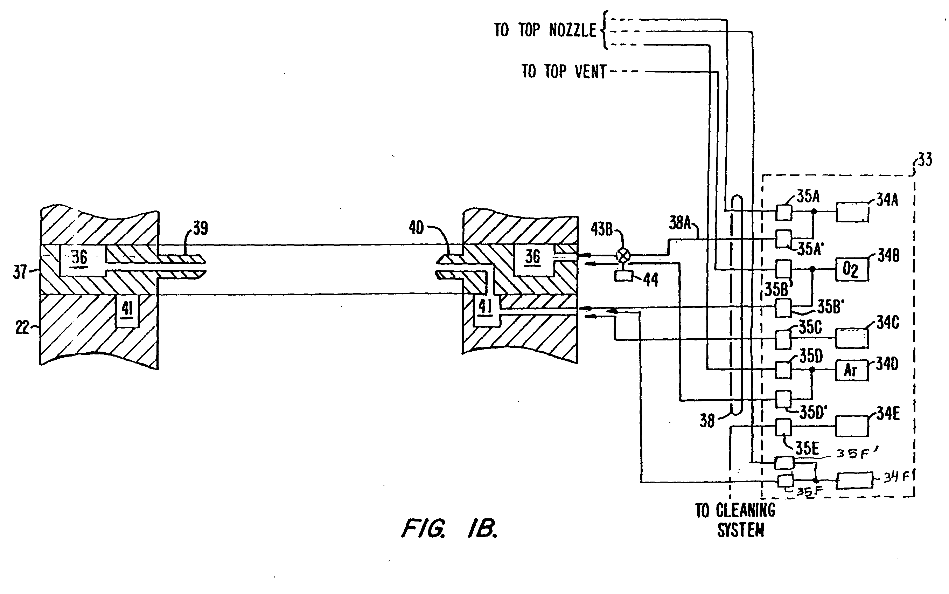

A gas delivery system 33 provides gases from several sources, 34A-34F chamber for processing the substrate via gas delivery lines 38 (only some of which are shown). As would be understood by a person of skill in the art, the actual sources used for sources 34A-34F and the actual connection of delivery lines 38 to chamber 13 varies depending on the deposition and cleaning processes executed within chamber 13. Gases are introduced into chamber 13 through a gas ring 37 and/or a top nozzle 45. Fig. 1B is a simplified, partial cross-sectional view of chamber 13 showing additional details of gas ring 37.

In one embodiment, first and second gas sources, 34A and 34B, and first and second gas flow controllers, 35A' and 35B', provide gas to ring plenum 36 in gas ring 37 via gas delivery lines 38 (only some of which are shown). Gas ring 37 has a plurality of source gas nozzles 39 (only one of which is shown in Fig. 1B for purposes of illustration) that provide a uniform flow of gas over the substrate. Nozzle length and nozzle angle may be changed to allow tailoring of the uniformity profile and gas utilization efficiency for a particular process within an individual chamber.

Gas ring 37 also has a plurality of oxidizer gas nozzles 40 (only one of which is shown), which in a preferred embodiment are co-planar with and shorter than source gas nozzles 39, and in one embodiment receive gas from body plenum 41. In some embodiments it is desirable not to mix source gases and oxidizer gases before injecting the gases into chamber 13. In other embodiments, oxidizer gas and source gas may be mixed prior to injecting the gases into chamber 13 by providing apertures (not shown) between body plenum 41 and gas ring plenum 36. In one embodiment, third and fourth gas sources, 34C and 34D, and third and fourth gas flow controllers, 35C and 35D', provide gas to body plenum via gas delivery lines 38. The nitrogen source 34F provides nitrogen gas ($N_2$) to oxidizer nozzles 40 of the gas ring 37 to the chamber for process steps utilizing nitrogen plasma. Alternatively, the nitrogen gas could be delivered to the chamber through other or additional inlets, such as the top nozzle 45 via gas flow controller 35F'. Additional valves, such as 43B (other valves not shown), may shut off gas from the flow controllers to the chamber. In a preferred embodiment, the gas nozzles 39 and 40 of gas ring 37 are made from an aluminum oxide ceramic.

In embodiments where flammable, toxic, or corrosive gases are used, it may be desirable to eliminate gas remaining in the gas delivery lines after a deposition. This may be accomplished using a 3-way valve, such as valve 43B, to isolate chamber 13 from delivery line 38A and to vent delivery line 38A to vacuum foreline 44, for example. As shown in Fig. 1A, other similar valves, such as 43A and 43C, may be incorporated on other gas delivery lines. Such 3-way valves may be placed as close to chamber 13 as practical, to minimize the volume of the unvented gas delivery line (between the 3-way valve and the chamber). Additionally, two-way (on-off) valves (not shown) may be placed between a mass flow controller ("MFC") and the chamber or between a gas source and an MFC.

Referring again to Fig. 1A, chamber 13 also has top nozzle 45 and top vent 46. Top nozzle 45 and top vent 46 allow independent control of top and side flows of the gases, which improves film uniformity and allows fine adjustment of the film's deposition and doping parameters. Top vent 46 is an annular opening around top nozzle 45. In one embodiment, first gas source 34A supplies source gas nozzles 39 and top nozzle 45. Source nozzle MFC 35A' controls the amount of gas delivered to source gas nozzles 39 and top nozzle MFC 35A controls the amount of gas delivered to top gas nozzle 45. Similarly, two MFC's 35B and 35B' may be used to control the flow of oxygen to both top vent 46 and oxidizer gas nozzles 40 from a single source of oxygen, such as source 34B. The gases supplied to top nozzle 45 and top vent 46 may be kept separate prior to flowing the gases into chamber 13, or the gases may be mixed in top plenum 48 before they flow into chamber 13. Separate sources of the same gas may be used to supply various portions of the chamber.

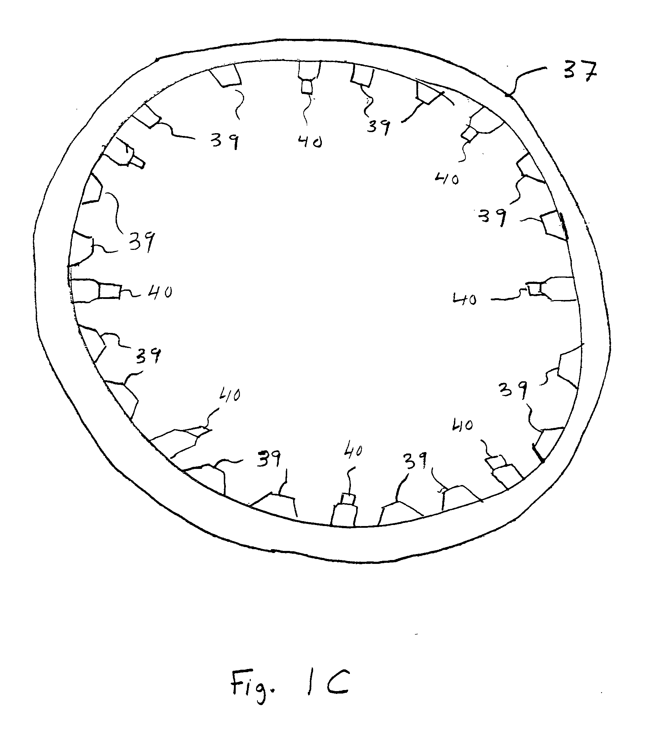

The configuration of source gas nozzles 39 and oxidizer gas nozzles 40 may be important in certain embodiments of the present invention. Fig. 1C depicts a simplified horizontal cross section of an embodiment of gas ring 37 depicted in Fig. 1B. In this embodiment gas ring 37 comprises 16 source nozzles 39 uniformly distributed about a periphery of gas ring 37. Gas ring 37 further comprises 8 oxidizer gas nozzles 40 uniformly distributed about the periphery of gas ring 37.

A remote microwave-generated plasma cleaning system 50 is provided to periodically clean deposition residues from chamber components. The cleaning system includes a remote microwave generator 51 that creates a plasma from a cleaning gas source 34E (e.g., molecular fluorine, nitrogen trifluoride, other fluorocarbons or equivalents) in reactor cavity 53. The reactive species resulting from this plasma are conveyed to chamber 13 through cleaning gas feed port 54 via applicator tube 55. The materials used to contain the cleaning plasma (e.g., cavity 53 and applicator tube 55) must be resistant to attack by the plasma. The distance between reactor cavity 53 and feed port 54 should be kept as short as practical, since the concentration of desirable plasma species may decline with distance from reactor cavity 53. Generating the cleaning plasma in a remote cavity allows the use of an efficient microwave generator and does not subject chamber components to the temperature, radiation, or bombardment of the glow discharge that may be present in a plasma formed in situ. Consequently, relatively sensitive components, such as electrostatic chuck 20, do not need to be covered with a dummy wafer or otherwise protected, as may be required with an in situ plasma cleaning process.

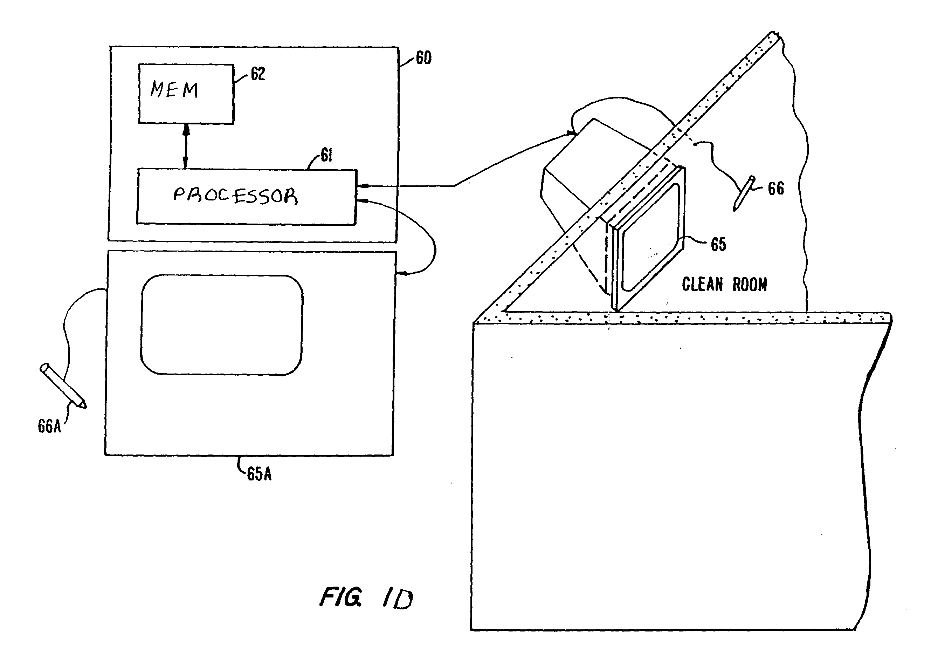

System controller 60 controls the operation of system 10. In a preferred embodiment, controller 60 includes a memory 62, such as a hard disk drive, a floppy disk drive (not shown), and a card rack (not shown) coupled to a processor 61. The card rack may contain a single-board computer (SBC) (not shown), analog and digital input/output boards (not shown), interface boards (not shown), and stepper motor controller boards (not shown). The system controller conforms to the Versa Modular European (VME) standard, which defines board, card cage, and connector dimensions and types. The VME standard also defines the bus structure as having a 16-bit data bus and 24-bit address bus. System controller 31 operates under the control of a computer program stored on the hard disk drive or through other computer programs, such as programs stored on a removable disk. The computer program dictates, for example, the timing, mixture of gases, RF power levels and other parameters of a particular process. The interface between a user and the system controller is via a monitor, such as a cathode ray tube (CRT) 65, and a light pen 66, as depicted in Fig. 1D.

Fig. 1D is an illustration of a portion of an exemplary system user interface used in conjunction with the exemplary CVD processing chamber of Fig. 1A. System controller 60 includes a processor 61 coupled to a computer-readable memory 62. Preferably, memory 62 may be a hard disk drive, but memory 62 may be other kinds of memory, such as ROM, PROM, and others.

System controller 60 operates under the control of a computer program 63 stored in a computer-readable format within memory 62. The computer program dictates the timing, temperatures, gas flows, RF power levels and other parameters of a particular process. The interface between a user and the system controller is via a CRT monitor 65 and a light pen 66, as depicted in Fig. 1C. In a preferred embodiment, two monitors, 65 and 65A, and two light pens, 66 and 66A, are used, one mounted in the clean room wall (65) for the operators and the other behind the wall (65A) for the service technicians. Both monitors simultaneously display the same information, but only one light pen (e.g. 66) is enabled. To select a particular screen or function, the operator touches an area of the display screen and pushes a button (not shown) on the pen. The area touched confirms being selected by the light pen by changing its color or displaying a new menu, for example.

The computer program code can be written in any conventional computer-readable programming language such as 68000 assembly language, C, C++, FORTRAN, Pascal or other language. Suitable program code is entered into a single file, or multiple files, using a conventional text editor and is stored or embodied in a computer-usable medium, such as a memory system of the computer. If the entered code text is in a high level language, the code is compiled, and the resultant compiler code is then linked with an object code of precompiled windows library routines. To execute the linked compiled object code, the system user invokes the object code causing the computer system to load the code in memory. The CPU reads the code from memory and executes the code to perform the tasks identified in the program.

Fig. 1E shows an illustrative block diagram of the hierarchical control structure of computer program 70. A user enters a process set number and process chamber number into a process selector subroutine 73 in response to menus or screens displayed on the CRT monitor by using the light pen interface. The process sets are predetermined sets of process parameters necessary to carry out specified processes, and are identified by predefined set numbers. Process selector subroutine 73 identifies (i) the desired process chamber in a multichamber system, and (ii) the desired set of process parameters needed to operate the process chamber for performing the desired process. The process parameters for performing a specific process relate to conditions such as process gas composition and flow rates, substrate temperature, pressure, plasma conditions such as RF power levels, and chamber dome temperature, and are provided to the user in the form of a recipe. The parameters specified by the recipe are entered utilizing the light pen/CRT monitor interface.

The signals for monitoring the process are provided by the analog and digital input boards of system controller 60, and the signals for controlling the process are output on the analog and digital output boards of system controller 60.

A process sequencer subroutine 75 comprises program code for accepting the identified process chamber and set of process parameters from the process selector subroutine 73 and for controlling operation of the various process chambers. Multiple users can enter process set numbers and process chamber numbers, or a single user can enter multiple process set numbers and process chamber numbers; sequencer subroutine 75 schedules the selected processes in the desired sequence. Preferably, sequencer subroutine 75 includes a program code to perform the steps of (i) monitoring the operation of the process chambers to determine if the chambers are being used, (ii) determining what processes are being carried out in the chambers being used, and (iii) executing the desired process based on availability of a process chamber and type of process to be carried out. Conventional methods of monitoring the process chambers can be used, such as polling. When scheduling which process is to be executed, sequencer subroutine 75 can be designed to take into consideration the "age of each particular user-entered request, or the present condition of the process chamber being used in comparison with the desired process conditions for a selected process, or any other relevant factor a system programmer desires to include for determining scheduling priorities.

After sequencer subroutine 75 determines which process chamber and process set combination is going to be executed next, sequencer subroutine 75 initiates execution of the process set by passing the particular process set parameters to a chamber manager subroutine 77a-c, which controls multiple processing tasks in chamber 13 and possibly other chambers (not shown) according to the process set sent by sequencer subroutine 75.

Examples of chamber component subroutines are substrate positioning subroutine 80, process gas control subroutine 83, pressure control subroutine 85, and plasma control subroutine 90. Those having ordinary skill in the art will recognize that other chamber control subroutines can be included depending on what processes are selected to be performed in chamber 13. In operation, chamber manager subroutine 77a selectively schedules or calls the process component subroutines in accordance with the particular process set being executed. Chamber manager subroutine 77a schedules process component subroutines in the same manner that sequencer subroutine 75 schedules the process chamber and process set to execute. Typically, chamber manager subroutine 77a includes steps of monitoring the various chamber components, determining which components need to be operated based on the process parameters for the process set to be executed, and causing execution of a chamber component subroutine responsive to the monitoring and determining steps.

Operation of particular chamber component subroutines will now be described with reference to Figs. 1A and 1E. Substrate positioning subroutine 80 comprises program code for controlling chamber components that are used to load a substrate onto substrate support number 18. Substrate positioning subroutine 80 may also control transfer of a substrate into chamber 13 from, e.g., a PECVD reactor or other reactor in the multichamber system, after other processing has been completed.

Process gas control subroutine 83 has program code for controlling process gas composition and flow rates. Subroutine 83 controls the open/close position of the safety shut-off valves and also ramps up/ramps down the mass flow controllers to obtain the desired gas flow rates. All chamber component subroutines, including process gas control subroutine 83, are invoked by chamber manager subroutine 77a. Subroutine 83 receives process parameters from chamber manager subroutine 77a related to the desired gas flow rates.

Typically, process gas control subroutine 83 opens the gas supply lines, and repeatedly (i) reads the necessary mass flow controllers, (ii) compares the readings to the desired flow rates received from chamber manager subroutine 77a, and (iii) adjusts the flow rates of the gas supply lines as necessary. Furthermore, process gas control subroutine 83 may include steps for monitoring the gas flow rates for unsafe rates and for activating the safety shut-off valves when an unsafe condition is detected.

Some processes flow an inert gas, such as argon, into chamber 13 to stabilize the pressure in the chamber before reactive process gases are introduced. For these processes, the process gas control subroutine 83 is programmed to include steps for flowing the inert gas into chamber 13 for an amount of time necessary to stabilize the pressure in the chamber. The steps described above may then be carried out.

Additionally, when a process gas is to be vaporized from a liquid precursor, the process gas control subroutine 83 may include steps for bubbling a delivery gas such as helium through the liquid precursor in a bubbler assembly or for introducing the helium to a liquid injection valve. For this type of process, the process gas control subroutine 83 regulates the flow of the delivery gas, the pressure in the bubbler, and the bubbler temperature to obtain the desired process gas flow rates. As discussed above, the desired process gas flow rates are transferred to process gas control subroutine 83 as process parameters.

Furthermore, the process gas control subroutine 83 includes steps for obtaining the necessary delivery gas flow rate, bubbler pressure, and bubbler temperature for the desired process gas flow rate by accessing a stored table containing the necessary values for a given process gas flow rate. Once the necessary values are obtained, the delivery gas flow rate, bubbler pressure and bubbler temperature are monitored, compared to the necessary values and adjusted accordingly.

The process gas control subroutine 83 may also control the flow of heat-transfer gas, such as helium (He), through the inner and outer passages in the wafer chuck with an independent helium control (IHC) subroutine (not shown). The gas flow thermally couples the substrate to the chuck. In a typical process, the plasma and the chemical reactions that form the layer heat the wafer, and the He cools the substrate through the chuck, which may be water-cooled. This keeps the substrate below a temperature that may damage preexisting features on the substrate.

Pressure control subroutine 85 includes program code for controlling the pressure in chamber 13 by regulating the size of the opening of throttle valve 26 in the exhaust portion of the chamber. There are at least two basic methods of controlling the chamber with the throttle valve. The first method relies on characterizing the chamber pressure as it relates to, among other things, the total process gas flow, the size of the process chamber, and the pumping capacity. The first method sets throttle valve 26 to a fixed position. Setting throttle valve 26 to a fixed position may eventually result in a steady-state pressure.

Alternatively, the chamber pressure may be measured, with a manometer for example, and the position of throttle valve 26 may be adjusted according to pressure control subroutine 85, assuming the control point is within the boundaries set by gas flows and exhaust capacity. The former method may result in quicker chamber pressure changes, as the measurements, comparisons, and calculations associated with the latter method are not invoked. The former method may be desirable where precise control of the chamber pressure is not required, whereas the latter method may be desirable where an accurate, repeatable, and stable pressure is desired, such as during the deposition of a layer.

When pressure control subroutine 85 is invoked, the desired, or target, pressure level is received as a parameter from chamber manager subroutine 77a. Pressure control subroutine 85 measures the pressure in chamber 13 by reading one or more conventional pressure manometers connected to the chamber; compares the measured value(s) to the target pressure; obtains proportional, integral, and differential (PID) values from a stored pressure table corresponding to the target pressure, and adjusts throttle valve 26 according to the PID values obtained from the pressure table. Alternatively, pressure control subroutine 85 may open or close throttle valve 26 to a particular opening size to regulate the pressure in chamber 13 to a desired pressure or pressure range.

Plasma control subroutine 90 comprises program code for controlling the frequency and power output setting of RF generators 31 A and 31 B and for tuning matching networks 32A and 32B. Plasma control subroutine 90, like the previously described chamber component subroutines, is invoked by chamber manager subroutine 77a.

An example of a system that may incorporate some or all of the subsystems and routines described above would be the ULTIMA™ system, manufactured by APPLIED MATERIALS, INC., of Santa Clara, California, configured to practice the present invention. Further details of such a system are disclosed in U.S. Patent Application No. 08/679,927, filed July 15, 1996, entitled "Symmetric Tunable Inductively-Coupled HDP-CVD Reactor," having Fred C. Redeker, Farhad Moghadam, Hirogi Hanawa, Tetsuya Ishikawa, Dan Maydan, Shijian Li, Brian Lue, Robert Steger, Yaxin Wang, Manus Wong and Ashok Sinha listed as co-inventors, the disclosure of which is incorporated herein by reference. The described system is for exemplary purpose only. It would be a matter of routine skill for a person of skill in the art to select an appropriate conventional substrate processing system and computer control system to implement the present invention.

III. Exemplary Structures

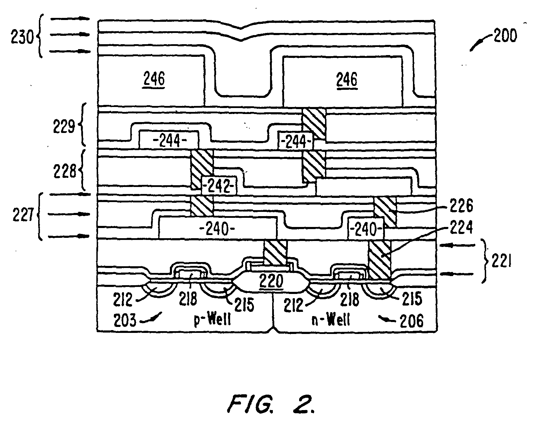

Fig. 2 illustrates a simplified cross-sectional view of an integrated circuit 200, which may be made in accordance with use of the present invention. As shown, integrated circuit 200 includes NMOS and PMOS transistors 203 and 206, which are separated and electrically isolated from each other by a field oxide region 220 formed by local oxidation of silicon (LOCOS), or other technique. Alternatively, transistors 203 and 206 may be separated and electrically isolated from each other by a groove trench isolation (not shown) when transistors 203 and 206 are both NMOS or both PMOS. Each transistor 203 and 206 comprises a source region 212, a drain region 215 and a gate region 218.

A premetal dielectric (PMD) layer 221 separates transistors 203 and 206 from metal layer 240 with connections between metal layer 240 and the transistors made by contacts 224. Metal layer 240 is one of four metal layers, 240, 242, 244 and 246, included in integrated circuit 200. Each metal layer 240, 242, 244, and 246 is separated from adjacent metal layers by respective inter-metal dielectric (IMD) layers 227, 228, or 229. Any or all of IMD layers 227, 228, or 229 can be deposited in accordance with embodiments of the present invention. Adjacent metal layers are connected at selected openings by vias 226. Deposited over metal layer 246 are planarized passivation layers 230.

It should be understood that simplified integrated circuit 200 is for illustrative purposes only. One of ordinary skill in the art could implement use of the present invention in relation to fabrication of other integrated circuits such as microprocessors, application specific integrated circuits (ASICs), memory devices, and the like. Further, the present invention may be applied to PMOS, NMOS, CMOS, bipolar, or BiCMOS devices.

IV. Exemplary FSG depostion

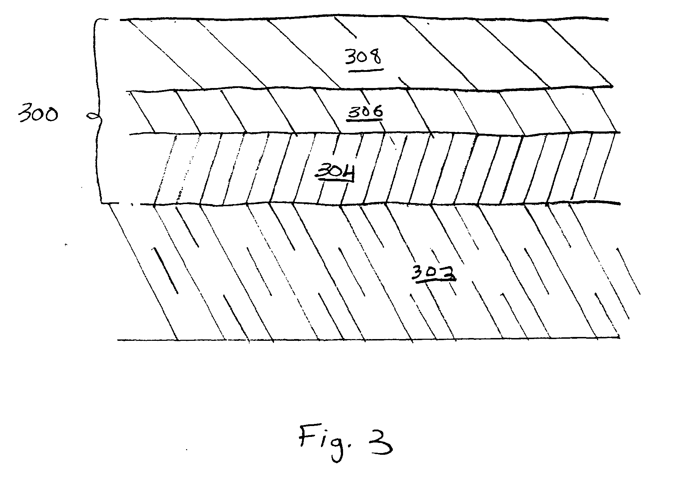

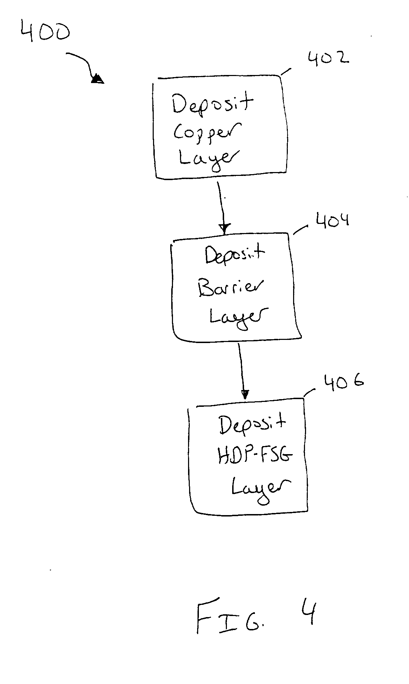

The present invention improves adhesion of an HDP-FSG layer to an overlying or underlying silicon nitride ($Si_xN_y$) layer. The method is best understood with reference to Figs. 3 and 4. Fig. 3 represents a multilayered film 300 deposited on a substrate 302 according to one embodiment of the present invention. In a preferred embodiment, the substrate 302 is a semiconductor wafer of an intermediate stage of processing. Thus, substrate 302 includes various layers and partially formed devices which are not shown in Fig. 3. Film 300 generally comprises a copper layer 304, a barrier layer 306 and an FSG layer 308. The film may optionally include a cap layer (not shown) on top of the FSG layer.

Fig. 4 depicts a flow diagram of one embodiment of the method of the present invention used in a copper damascene process. As shown in Fig. 4, copper layer 304 is deposited on substrate 302 at step 402. Any conventional technique including physical vapor deposition (PVD) or chemical vapor deposition (CVD) may be used to deposit copper layer 304. Next, barrier layer 306 is deposited over copper layer 304 (step 404). Barrier layer 306 may be any type of material normally used to prevent diffusion of material from layer 304 to layer 308 or vice versa and in one specific embodiment is a silicon nitride layer. Alternatively, layer 306 may serve as an etch stop or hard mask, as in damascene-applications. After depositing barrier layer 306, FSG layer 308 is deposited (step 408) using HDP deposition techniques and using minimal, and in some embodiments, no bias RF power.

FSG layer 308 is deposited by heating substrate 302 up to or near the deposition temperature and then introducing the deposition gases into the HDP chamber. Typically substrate 302 is heated to a temperature of between 350°C and 450°C prior to and during deposition. The substrate may be heated by a heater incorporated into substrate support member 18 and/or by the plasma.

In some embodiments where the plasma is used to heat the substrate prior to deposition, the content of the heating plasma is important in some applications. For example, many capacitively coupled oxide depostition process recipies, e.g., PECVD of FSG, heat a semiconductor wafer in a plasma of oxygen and argon prior to deposition of FSG. This ensures an established flow of oxygen for subsequent oxide deposition. For deposition of oxide over copper, barrier layer 306 normally comprises $Si_xN_y$ as a barrier to copper diffusion. However, the present inventors have found that when a high density plasma of argon and oxygen heats a copper coated wafer, the oxygen can attack the copper through the $Si_xN_y$ layer 306. The resulting oxidation may damage or destroy copper layer 304 and may severely contaminate the chamber as well. To protect copper layer 304 and the chamber from oxidation by the high density plasma used in the present invention for deposition of the FSG layer, the present invention heats the wafer in an oxygen-free high-density plasma. In one embodiment an inert gas, such as Ar, forms the plasma. Alternatively, other inert or substantially inert gases including helium, neon, krypton, xenon and/or nitrogen, may be used to form the plasma.

Sometimes, a low power RF bias can be used to heat the wafer before and during FSG deposition using a closed loop with wafer backside emissivity for temperature control. For example, expitaxial, (epi) wafers, because of their very low resistivity, cannot be adequately heated with only source RF power and application of a bias RF power is necessary to assist in heating the wafer to the desired temperature. For example, up to 400 W for 200 mm wafers or ~1.3 W/cm$^2$ of bias power may be used to heat epitaxial silicon (epi) wafers to the desired temperature during FSG deposition. More preferably, the bias is between 200 W and 300 W for a 200 mm wafer, corresponding to a bias RF power density between about 0.64 and about 1.0 W/cm$^2$. Backside He cooling may optionally be used for process temperature control and targeting. A preferred gap-fill process, by comparison, uses a Bias RF power of 2500 Watts or more for a 200 mm wafer, corresponding to a bias power density of greater than approximately 8 W/cm$^2$.

After heating substrate 302 to the desired temperature, a flow of deposition gases is quickly established. In one embodiment, a flow of oxygen is introduced into the chamber along with the inert gas after the substrate is heated to a desired temperature. Approximately 1-2 seconds after the oxygen flow is introduced, the remaining deposition gases are then introduced into the chamber. To deposit a layer of FSG, the deposition gases generally include a gaseous mixture of a silicon containing gas, a fluorine containing gas, and an oxygen containing gas. The silicon containing gas is typically a silane such as monosilane ($SiH_4$). Alternatively, the silicon containing gas may be another silane such as disilane ($Si_2H_6$), trisilane ($Si_3H_8$), etc. The oxygen containing gas is typically oxygen ($O_2$) but could also be $CO_2$ or $N_2O$. The fluorine containing gas is typically $SiF_4$ but could also be $CF_4$, $C_2F_6$ and similar gases. In a specific example using a chamber such as chamber 13, the deposition gases are provided at flow rates ranging from 0 to 60 standard cubic centimeters per minute (sccm) for $SiH_4$, from 20 to 80 sccm for $SiF_4$, from 100 to 400 sccm for $O_2$, and from 50 to 400 sccm for Ar. Vacuum system 70 typically maintains the chamber pressure at between 2 and 10 millitorr. The chamber wall temperature is typically maintained at between 120°C and 170°C. Alternatively, in some applications, $SiH_4$ is not used and the $SiF_4$ provides both the silicon containing gas and the fluorine containing gas.

All previously used HDP-FSG deposition processes known to the inventors bias the substrate at a relatively high bias RF power level during deposition of the film. Such a bias is typically used during HDP deposition processes in order to enhance ion bombardment and sputtering of the layer as it is deposited. The method of the present invention, however, applies minimal or no bias power during deposition of the FSG layer. The present inventors have found that such a deposition sequence results in an improvement in the adherence of the deposited HDP-FSG layer to a barrier layer, such as silicon nitride. According to the present invention, bias RF power is applied during deposition of the HDP-FSG layer at power level of less than or equal to about 1.3 Watts/cm$^2$ (approximately 400 Watts in an Ultima HDP chamber outfitted for 200 mm wafers). In specific embodiments of the invention, no bias RF power is applied at all and only source RF power is employed for plasma generation and substrate temperature control. For example, in an HDP chamber such as chamber 13, between 1500 and 4800 watts of RF power are applied to top coil 29 and between 2000 and 4800 watts are applied to side coil 30.

The total source RF power density to the wafer surface controls the deposition rate, the thickness uniformity and the F concentration uniformity across the wafer surface; i.e., the surface of FSG layer 308. Total Source RF power density at the wafer surface is approximately equal to the total source power provided by the top and side coils divided by the area of the wafer surface that is exposed to the plasma. Without the bias or with minimal bias power, adhesion of FSG layer 308 to barrier layer 306 improves. FSG layers deposited without a bias can be referred to as unbiased fluorinated oxides (UFO) or source-only fluorinated oxides (SOFO). If the substrate 302 is not biased, and substrate support member 18 does not include a heater, a greater total source power is typically required to heat the wafer. For example, the total Source RF power provided to a 200 mm diameter substrate using the gap-fill process is typically about 5000 watts, corresponding to a source power density of about 15.9 watts per square centimeter (W/$cm^2$) of wafer surface. In an embodiment of the present invention, the total source power is preferably about 6500 watts or greater, i.e., the source power density is greater than approximately 20.7 W/$cm^2$.

Processing substrate 302 in this fashion during FSG deposition produces a $1\sigma$ thickness non-uniformity of less than 1% and a $1\sigma$ F concentration non-uniformity of less than 1%. One optimized gap-fill process by contrast produces about 2.5% thickness non-uniformity and about 4% F concentration non-uniformity. Therefore, the method of the present invention improves both thickness and F concentration non-uniformity as compared to prior art process.

The inventors discovered that HDP-FSG films deposited according to the present invention have another benefit, reduced chamber clean time as compared to prior art HDP-FSG processes. In all prior art HDP-FSG processes known to the inventors, there is sputtering occurring simultaneously on the growing film through the application of a relatively high RF bias. As previously mentioned, application of such a bias improved the gap fill properties of the film. It also decreased the deposition rate of the HDP-FSG film on the substrate, however, as compared to the deposition rate of the film on the chamber walls and other components that were not similarly biased. Thus, for example, one previously known process used to deposit a 1500 Å HDP-FSG layer on a substrate may actually deposit about 2500 Å of HDP-FSG on the chamber walls. The present invention, by way of contrast, deposits film on the substrate at a deposition rate approximately equal to the rate the film deposits on the chamber walls. Thus, depositing a 1500 Å HDP-FSG layer according to the present invention results in deposition of approximately 1500 Å of film on the chamber wall. This in turn results in a decrease in the time required to clean the chamber -- etching 1500 Å of film from the walls takes less time than etching 2500 Å.

Adjustment of the flow of source and oxidizer gases to the chamber can provide additional improvement of the uniformity of FSG thickness and F concentration. For example, previous HDP-CVD processes were directed toward gap fill with FSG. Gap fill processes use simultaneous deposition and removal of material to fill narrow gaps etched in a layer of metal. In these processes a high flow of $O_2$ can lead to an increase in ratio of deposition to removal. An undesirably high deposition to removal ratio could prevent proper gap fill. Therefore, a low $O_2$ flow rate is normally desirable in gap fill applications. Consequently, in previous gap fill applications with FSG, both $O_2$ and $SiF_4$ are introduced to the chamber through the same set of nozzles, e.g., oxidizer nozzles 40 in gas ring 37 of Fig 1B and 1C. Source gases, such as $SiH_4$, and inert gases, such as Ar, flow through source nozzles 39.

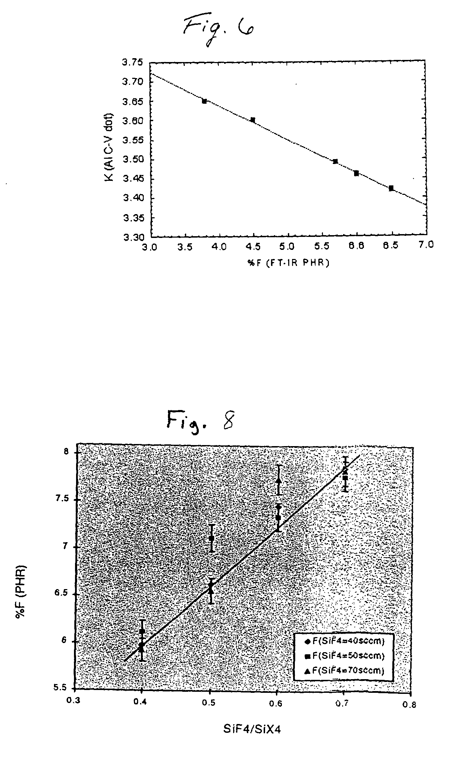

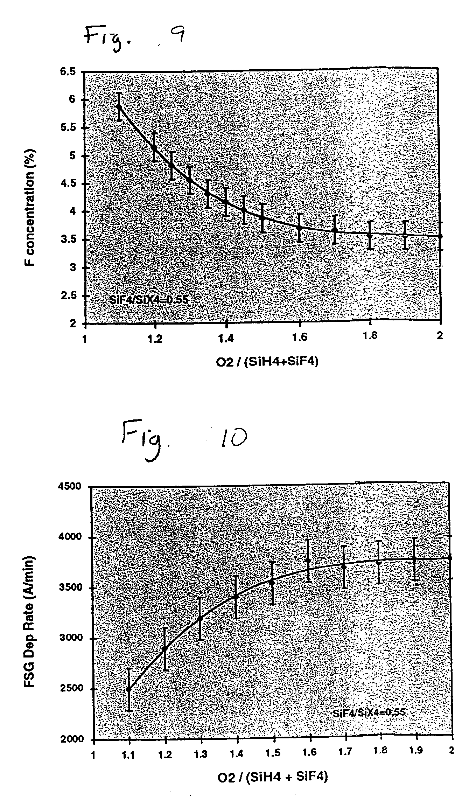

Blanket deposition processes commonly used in copper damascene applications do not normally deposit and remove material simultaneously. The inventors have found that the deposition rate of a blanket FSG process can be enhanced by increasing the flow rate of oxygen containing gas to the chamber. The flow rate can be enhanced by introducing the oxygen containing gas, e.g., $O_2$, through a first set of gas nozzles and the other gases, i.e., source gases and inert gases, though a second set of nozzles. For example, $O_2$ flows into chamber 13 via oxidizer nozzles 40 in gas ring 37, while source gases, such as Ar, $SiH_4$ and $SiF_4$ flow into the chamber through source nozzles 39. The inventors have found that an increase in $O_2$ flow relative to $SiH_4$ and $SiF_4$ flows results in an increase in the deposition rate of the film (see Fig. 10) and a wider process window (see e.g., Fig. 11 where an $O_2/(SiH_4 + SiF_4)$ ratio of between about 1.6 and 2.0 has a minimal effect on the film's refractive index).

To further improve the thickness uniformity and fluorine concentration uniformity across the wafer, the wafer may be substantially thermally decoupled from the substrate support member 18, e.g.; by turning off the helium backside gas cooling and/or dechucking substrate 302. The substrate temperature is typically maintained at between 350 and 450° C during FSG deposition. Generally, the substrate is heated with the plasma using source RF power only, i.e., with no Bias RF power applied to the substrate. The compressive modulus of the resulting FSG film is higher for a film deposited without bias compared to an FSG film deposited with a bias. Higher compressive modulus is desirable in dielectric films because it counteracts the tensile properties of the copper metalization. High thermal conductivity wafers, such as epi wafers, may be heated during deposition using a low bias power as described above.

V. Exemplary Damascene Process

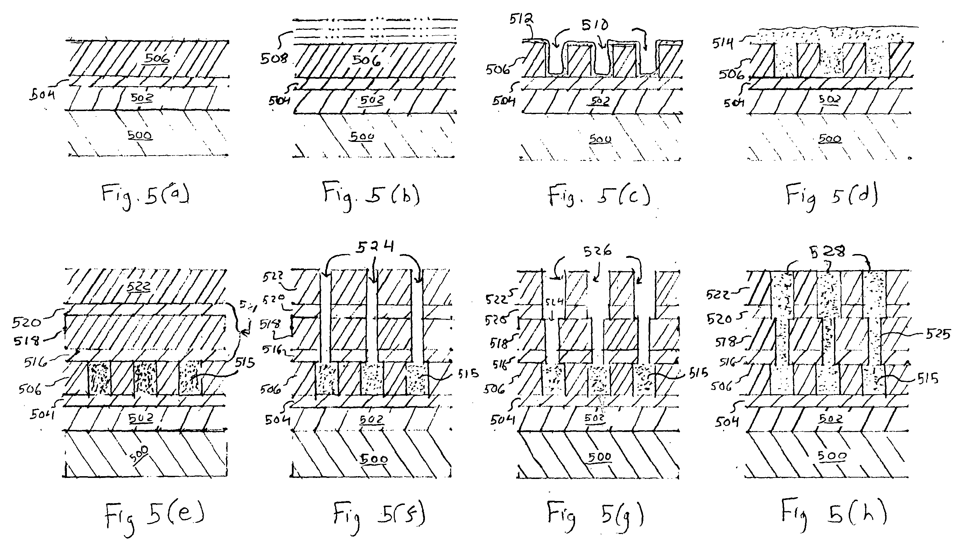

The barrier layer and thin film deposition described above with respect to Figs. 3 and 4 may be utilized in a damascene process. An example of a dual-damascene process integration scheme that utilizes the FSG layer deposition in forming an IMD layer is depicted in Figs. 5(a)-5(h). The dual damascene process begins with the deposition of an oxide layer 502 over a silicon substrate 500 as shown in Fig. 5(a). A barrier layer 504, is deposited over oxide layer 502, e.g., by HDP-CVD using $SiH_4$ and $N_2$ or PECVD using $SiH_4 + NH_3/N_2$. In some applications layer 504 acts as a hardmask or etch-stop layer. A first FSG layer 506 is deposited, e.g., using the HDP-CVD method described above. First FSG layer 506 may be deposited in the same chamber as barrier layer 504 to enhance process integration. A first patterned photoresist layer 508 covers FSG layer 506 during a first photolithography as shown in Fig. 5(b). A first etch forms a first set of gaps 510 in first FSG layer 506 down to hardmask layer 504 as shown in Fig. 5(c).

After the first etch, photoresist 508 is stripped, e.g., by ashing in an oxidizing environment. Gaps 510 and first FSG layer 506 are then covered with a layer of metal, such as aluminum or copper. In the case of copper, a seed layer 512 (Fig. 5(c)) is deposited over gaps 510 and first FSG layer 506. A first bulk copper layer 514 is deposited to fill the gaps 510 as shown in Fig. 5 (d). In some applications, a barrier layer (not shown) is deposited over first FSG layer 506 and gaps 510 prior to deposition of seed layer 512. The barrier layer prevents interdiffusion of copper and FSG. Copper layer 514 is planarized, e.g., by CMP. Planarization of copper layer 514 forms, e.g., a first set of metal lines 515 in an interconnect structure.

After planarization, of copper layer 514, a second barrier layer 516, a second FSG layer 518, a third barrier layer 520 and third FSG layer 522 are deposited to form an IMD layer 521 as shown in Fig. 5(e). Second FSG layer 518 and third FSG layer 522 may be deposited by HDP-CVD as described above. Layers 518, 520, and 522 may be deposited in the same chamber, e.g., by HDP-CVD, without removing substrate 500 to enhance process integration for forming IMD layer 521. To prevent oxidation of copper layer 520 and contamination of the chamber, substrate 500 may be heated in a high-density Argon plasma without oxygen prior to depositing second FSG layer 518. A second lithography and etch forms vias 524 through layers 516, 518, 520 and 522 down to copper layer 514 as shown in Fig. 5(f). In Fig. 5(g), a third lithography and etch forms a second set of gaps 526. Gaps 526 define a second set of metal lines and vias 524 define a set of interconnects between the second set of metal lines and the first set of metal lines defined by gaps 510 and copper layer 514. Vias 524 and gaps 526 are then filled with a second bulk copper layer and the resulting structure is annealed and planarized as shown in Fig. 5(h). Gaps 526 define a second set of metal lines 528 and vias 524 define a set of interconnects 525 between the second set of metal lines 528 and the first set of metal lines 515.

Damascene processes are used in devices that use copper interconnects because there is currently no acceptable way to etch copper. Structures formed by damascene processes do not require a gap-fill dielectric and generally provide lower RC delays than similar structures formed using metal lines aluminum, tungsten, titanium or other metals. Furthermore, higher deposition rates may be used in damascene processes since gap-fill is not an issue. Any of barrier layers 506, 516 and 520 can be silicon nitride layers. Alternatively, it may be desirable to deposit one or more of barrier layers 506, 516 and 520 as silicon-carbon low-k barrier layers such as BLOK™ (Barrier Low K). BLOK™ is a trademark of Applied Materials, Inc. of Santa Clara, California..

VI. Experimental Results

Experiments performed in a HDP ultima chamber outfitted for 200 mm substrates tested the effect of Ar flow, $O_2$ flow, $SiF_4/SiH_4$ ratio, bias power and total source power on the HDP-FSG deposition process described above. The experimental results demonstrate that it is possible to deposit FSG layers at increased deposition rates, lower thickness and fluorine concentration non-uniformity across the wafer, and improved adhesion to underlying $Si_xN_y$, using HDP-CVD techniques according to embodiments of the presenf invention as compared to prior art techniques. Furthermore FSG layers may be deposited over $Si_xN_y$ on copper exhibit without contaminating the chamber.

The fluorine content generally determines the properties of a layer of FSG such as the dielectric constant. The fluorine content of the FSG is measured with Fourier Transform Infrared Spectroscopy (FTIR) in terms of the ratio of the heights of two absorption peaks. The height of an (SiF) peak generally indicates the presence of Si-F bonds. The height of an (SiO) peak generally indicates the presence of Si-O bonds. The fluorine concentration in the FSG is measured by percentage peak height ratio (% PHR) as follows:

$$\% \text{ PHR} = \frac{\text{height of Si - F peak}}{\text{height of Si - O stretching peak}} \times 100\%$$

Direct measurement of the fluorine content of the FSG has shown that the % PHR is roughly proportional to the atomic % fluorine (at. % F) in the FSG layer. The at. % F is sometimes approximated by the formula:

$$\text{at. \% F} = (\% \text{ PHR}) \times K + 2.6,$$

where K is an empirically determined constant of 1.15 and % PHR is between 3.5 and 7.0. The exact relationship between at. % F and % PHR depends on numerous factors such as the specific absorption peaks measured, the particular FTIR instrument, and the method used to directly measure the fluorine concentration.

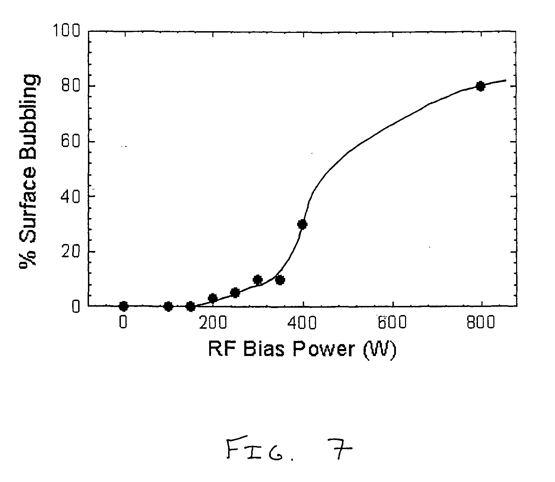

Fluorine concentration was measured with a Nicolet FTIR spectrometer using the signal strength ratio at about 1.0 micron. The Si-O peak is at approximately 1095 $cm^{-1}$ and the Si-F peak is at approximately 937 $cm^{-1}$. The signal strength ratio is roughly proportional to the atomic % of fluorine in the FSG layer. In one example a signal strength ratio of 6.5% corresponded to a fluorine concentration in the FSG of about 10-11 at. %. A capacitance-voltage (C-V) probe measured the dielectric constant of the FSG films. The relationship between at. % PHR and dielectric constant for the FSG film is depicted in Fig. 6. Note that, as expected, dielectric constant decreases with increasing F concentration.

Fig. 7 is a graph that shows the percentage of bubbling is visible on the surface of HDP-FSG films deposited at various bias power levels. The bubbling is measured after an anneal cycle during which the substrate having an HDP-FSG layer deposited over it was heated to a temperature of 410° C for 30 minutes. The HDP-FSG layers were deposited from a process gas that includes $SiF_4$, $SiH_4$, Ar and $O_2$ and the gas flows of each precursor were adjusted for each measured bias power level in order to deposit an FSG film having a fluorine concentration level of 6 % FTIR. As evident from Fig. 7, at bias power levels below 200 Watts almost no surface bubbling occurs while at bias power levels above 400 Watts (1.3 Watts/cm$^2$) 40% or more of the FSG layer's surface exhibits bubbling. As discussed above, such bubbling adversely impacts the adherence of the HDP-FSG layer to an underlying or overlying silicon nitride layer.

The presence of Ar in the deposition plasma improves the resulting characteristics of the deposited film. In one experiment, adhesion between the HDP-FSG film and HDP-CVD $Si_xN_y$ films passed six furnace anneal cycles at 410°C for 30 minutes. FSG films deposited with Ar showed no bubbling or delamination. Furthermore, films processed with Ar exhibited no outgassing in thermal desorption spectra (TDS) at temperatures up to 450°C. HDP-FSG films deposited without Ar, by contrast, exhibited several bubbles after the same adhesion test and slight outgassing in TDS at temperatures above 250°C. These results demonstrate that HDP-FSG deposited with Ar is compatible, for example, with a $Si_xN_y$ barrier layer or etch stop. The present inventors found that HDP-FSG films deposited according to the present invention and with argon have improved characteristics when compared to HDP-FSG films deposited without including argon in the deposition gas. It is believed that the addition of Ar improves the dissociation efficiency of $SiF_4$ molecule. It is known that the Si-F bond is very strong, thus difficult to break. However, Ar can be easily ionized in a plasma which acts as a catalyst for Si-F bond dissociation. If the $SiF_4$ is not dissociated completely, then there is a higher likelihood of $SiF_2$ deposition which renders the FSG unstable.

Similar results were obtained with HDP-FSG films deposited with Source RF power only. Although the TDS spectra were about the same for FSG films deposited with and without RF bias, films deposited with RF bias failed the adhesion test to $Si_xN_y$.

Tuning the $SiF_4$ and $SiH_4$ composition of the deposition plasma can easily control the HDP-FSG fluorine concentration. Fig. 8 depicts a graph of % F, as measured by peak height ratio, versus the flow rate ratio of $SiF_4/SiH_4$. The % F increases as the ratio of $SiF_4/SiH_4$ increases. Although the % F depends strongly on $SiF_4/SiH_4$ ratio, changes in the gas flows and other hardware parameters did not significantly alter process results. Therefore the HDP-FSG deposition process described herein has a robust process window.

Specifically, there is a large process window for the ratio of $O_2$ to ($SiH_4$ + $SiF_4$) in terms of % F, refractive index, and deposition rate. Fig. 9 depicts the dependence of % F PHR versus the $O_2/(SiH_4 +SiF_4)$ ratio. Note that the % F is relatively constant for $O_2/(SiH_4 +SiF_4)$ ratios of about 1.5 or greater. Fig. 10 depicts the dependence of FSG refractive index versus the $O_2/(SiH_4 + SiF_4)$ ratio. The refractive index saturates for $O_2/(SiH_4 +SiF_4)$ ratios of about 1.5 or greater. Fig. 11 depicts the dependence of FSG deposition rate versus the $O_2/(SiH_4 +SiF_4)$ ratio. The deposition rate saturates for $O_2/(SiH_4 +SiF_4)$ ratios of about 1.5 or greater.

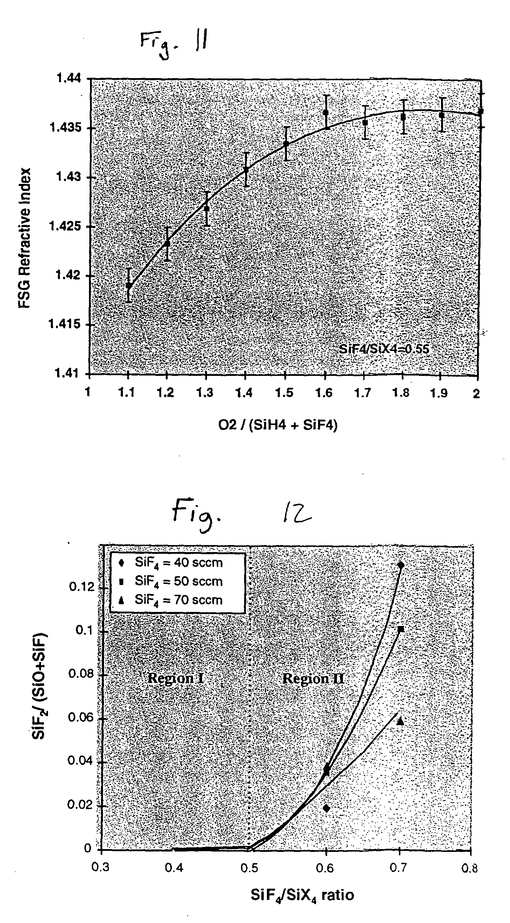

One parameter that may be varied to optimize HDP-FSG deposition is the $SiF_4/SiX_4$ ratio, i.e., the ratio of $SiF_4$ to ($SiF_4$ + $SiH_4$). Fig. 8 suggests that a higher $SiF_4/SiX_4$ ratio is more desirable since it produces higher % F and Fig. 6 shows that higher % F produces a lower dielectric constant. However, as shown in Fig. 12, a $SiF_4/SiX_4$ ratio above about 0.55 produces an FSG film having a high ratio of $SiF_2$ bonding compared to SiO and SiF. $SiF_2$ bonds are weak and prone to moisture attack. Consequently, $SiF_2$ bonds are generally undesirable in FSG films. Therefore, in a preferred embodiment of the invention, $SiF_4$ and $SiH_4$ flow into the chamber at flow rates having a ratio of $SiF_4/SiX_4$ of 0.55 or less.

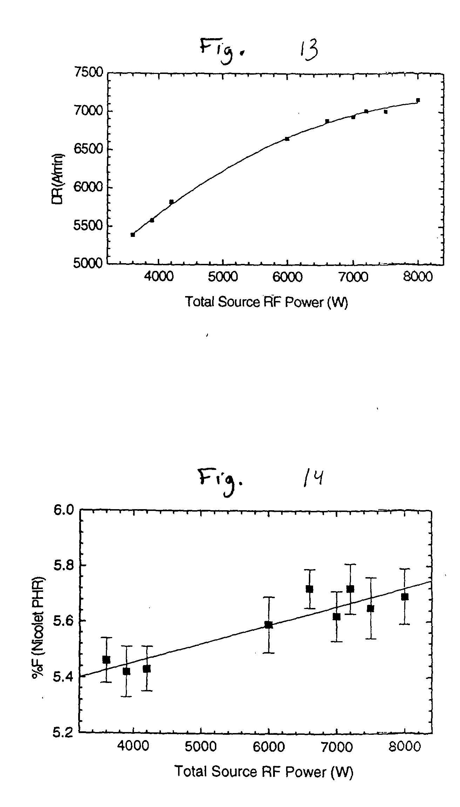

Another parameter that affects the deposition rate and % F of HDP-FSG films is the total source power. Fig. 13 depicts a graph of deposition rate as a function of total source RF power for HDP-FSG deposition according an embodiment of the present invention. The deposition rate increased by about 30% when the Source RF power increased from 4000 W to 6500 Watts for 200 mm wafers, i.e. from about 12.7 to about 20.6 W/cm$^2$. Above about 6500 W, the deposition rate tends to saturate. Fig. 14 depicts a graph of % F as a function of total source RF power for HDP-FSG deposition according to an embodiment of the present invention. The % F increased slightly when the Source RF power was increased from 4000 W to 6500 Watts for 200 mm wafers, i.e. from about 12.7 to about 20.6 W/cm$^2$ power density. Above about 6500 W, the % F tends to saturate.

The above experimental results suggest a set of process parameters for a preferred embodiment of the present invention. Specifically, the process parameters are:

   a) deposit FSG by HDP-CVD with $SiH_4$, $SiF_4$, and Ar;
   b) $O_2/(SiH_4 + SiF_4)$ ratio greater than about 1.5;

c) SiF$_4$/(SiH$_4$ + SiF$_4$) ratio less than about 0.55;

d) Wafer temperature about 350° C to 450° C;

e) Source RF power density greater than about 20.6 W/cm$^2$.

f) RF Bias power density between 0 and about 1.3 W/cm$^2$; and

g) thermally decouple the wafer from the pedestal, e.g., no backside gas cooling of the wafer, dechuck wafer.

Having fully described several embodiments of the present invention, many other equivalent or alternative methods of depositing the low dielectric constant oxide layer according to the present invention will be apparent to those skilled in the art. These alternatives and equivalents are intended to be included within the scope of the present invention.

**Claims**

1. A method for depositing a film on a substrate in a process chamber, said method comprising:

   (a) providing a gaseous mixture to the chamber; the gaseous mixture having a silicon containing gas, a fluorine containing gas, and an oxygen containing gas;
   (b) generating a high-density plasma from the gaseous mixture; and
   (c) depositing a fluorinated silicate glass (FSG) layer onto the substrate from the plasma without biasing the plasma towards the substrate or by applying a bias to the substrate at a bias power density of less than about 1.3 Watts per square centimeter.

2. The method of claim 1, further comprising: applying a total source power to the plasma, the total source power density being about 20.7 Watts per square centimeter or greater.

3. The method of claim 1 or claim 2, wherein the bias power density applied to the substrate during deposition of said FSG layer is 0.0 W/cm$^2$.

4. The method of any one of claims 1 to 3, wherein a ratio of a flow rate of the oxygen containing gas to a combined flow rate of the silicon containing and fluorine containing gases is greater than about 1.5.

5. The method of any one of claims 1 to 4, wherein a ratio of a flow rate of the fluorine containing gas to a combined flow rate of the silicon containing and fluorine containing gases is less than about 0.55.

6. The method of any one of claims 1 to 5, wherein the FSG has a fluorine concentration of 6.5 at. % or greater.

7. The method of claim 6, wherein the FSG has a fluorine concentration of between about 9.0 at. % and about 11.0 at. %.

8. The method of any one of claims 1 to 7, wherein the substrate is supported by a pedestal, the substrate being substantially thermally decoupled from the pedestal.

9. The method of any one of claims 1 to 8, wherein the fluorine containing gas is or comprises tetrafluorosilane (SiF$_4$).

10. The method of any one of claims 1 to 9, wherein the silicon containing gas is or comprises a silane.

11. The method of any one of claims 1 to 10, wherein said FSG layer is deposited on a barrier layer previously formed on the substrate.

12. The method of claim 11, wherein the barrier layer is or comprises a silicon nitride layer.

13. The method of any one of claims 1 to 12, wherein the FSG layer is deposited without applying a bias to the substrate.

14. The method of claim 12 or claim 13, wherein the FSG layer and silicon nitride layer are deposited as part of a copper damascene process.

15. The method of claim 14, further comprising: prior to depositing the FSG layer, heating the substrate in an in-situ plasma that does not comprise an oxygen-source.

16. The method of any one of claims 1 to 13, further comprising:
    depositing a layer of copper on the substrate prior to depositing the FSG layer, heating the substrate in an in-situ plasma that does not comprise an oxygen source.

17. The method of any one of claims 1 to 16, wherein a dielectric constant of said film is between 3.35 and 3.50.

18. A method for depositing a fluorine-doped silicon oxide layer on a substrate in a process chamber, the method comprising:

    (a) flowing a process gas comprising SiF$_4$, O$_2$ and Ar into the chamber;
    (b) forming a high-density plasma from the process gas by applying source RF power to the plasma at a power density of about 20.7 Watts per square centimeter or greater; and
(c) depositing the dielectric layer onto the substrate using the high-density plasma without biasing the substrate.

19. The method of claim 18, wherein said process gas further comprises $SiH_4$ and wherein a ratio of a flow rate of the $O_2$ to a combined flow rate of the $SiH_4$ and $SiF_4$ is greater than about 1.5.

20. The method of claim 18 or claim 19, wherein a ratio of a flow rate of the $SiF_4$ to a combined flow rate of the $SiH_4$ and $SiF_4$ is less than about 0.55.

21. A computer program product, which when read by a computer causes the said computer to control a substrate processing system, said system including a process chamber, a plasma generation system, a substrate holder, a gas delivery system configured to introduce gases into the process chamber, the computer program product including instructions for operating said system to form a thin film on a substrate disposed in the processing chamber in accordance with the following:

    (a) providing a gaseous mixture to the chamber, the gaseous mixture having a silicon containing gas, and an oxygen containing gas;
    (b) generating a high-density plasma from the gaseous mixture;
    (c) applying a bias power to the substrate at a bias power density of about 1.3 Watts per square centimeter or less; and
    (d) depositing the dielectric layer onto the substrate using the plasma.

22. A storage medium upon which is stored a computer program product as defined in claim 21.

23. A substrate processing system comprising:

    a housing defining a process chamber;
    a high density plasma generating system operatively coupled to said process chamber;
    a substrate holder configured to hold a substrate during substrate processing;
    a gas delivery system configured to introduce gases into said process chamber;
    a controller for controlling said gas delivery system and said heater; and
    a memory coupled to said controller comprising a computer-readable medium having a computer-readable program embodied therein for directing operation of said substrate processing system, said computer-readable program including

    (a) instructions for controlling said gas delivery system to flow a gaseous mixture containing flows of a silicon containing gas, a fluorine containing gas and an oxygen containing gas;
(b) instructions for controlling the plasma generating system to generate a high-density plasma from said gaseous mixture and to apply a bias to the substrate at a bias power density of about 1.3 Watts per square centimeter or less; and
(c) instructions for controlling the system to deposit an FSG layer the substrate using said plasma.

FIG. IA.

FIG. 1B.

Fig. 1C

FIG. 1D

EP 1 146 142 A2

**Processor Selector**
*Chamber Selection*
*Process Gas Flow*
*Temperature*
*Pressure*
*Plasma Power*

73

Process Sequencer

75

70

Chamber Manager    77b

Chamber Manager    77c

Chamber Manager
for CVD/Sputtering Chamber    77a

Substrate Positioning

Process Gas Control

Pressure Control

Plasma Control

80

83

85

90

FIG. 1E

FIG. 2.

Fig. 3

400

402

Deposit
Copper
Layer

404

Deposit
Barrier
Layer

406

Deposit
HDP-FSG
Layer

FIG. 4

Fig. 5(a)

Fig. 5 (b)

Fig. 5(c)

Fig 5(d)

Fig 5(e)

Fig 5(f)

Fig 5(g)

Fig 5(h)

FIG. 7

Fig. 6

Fig. 8

Fig. 9

Fig. 10

Fig. 11

Fig. 12

Fig. 13

Fig. 14